# EUROPEAN PATENT APPLICATION

(11) **EP 1 708 256 A1**
(43) Date of publication of application: **04.10.2006**
(21) Application number: 03768153.3
(22) Date of filing: 24.12.2003
(51) Int. Cl.: H01L 21/68, B65D 85/86, E05B 65/02

(54) **COVER ATTACHING/DETACHING DEVICE OF CARRY CONTAINER**

(71) Applicant: Right Mfg. Co., Ltd., Itabashi-ku Tokyo 174-8633 (JP)
(72) Inventor: NAGATA, Tatsuhiko, Itabashi-ku, Tokyo 174-8633 (JP)
(74) Representative: Ruttensperger, Bernhard
(86) International application number: PCT/JP2003/016563
(87) International publication number: WO 2005/062373

(57) **Abstract**

A cover can be unlocked even if a rectangular engaging groove runs out of alignment to some extent during previous steps or during a carrying operation from a previous step. A T-shaped key 14c consists of a head 141 and a neck 142 functioning as a rotation axis for the head 141. The head 141 has four inclined sides 143 along the both longitudinal sides tapering from the center toward the end. The T-shaped key 14c also has chamfers 144 formed on the topside of each inclined sides 143.

## Description

### BACKGROUND OF THE INVENTION

### Field of the Invention

The present invention relates to a pod cover removing-installing apparatus for a pod which contains and transfers thin substrates such as semiconductor wafers from one space to another space while maintaining the cleanliness of both spaces.

### Description of the Background Art

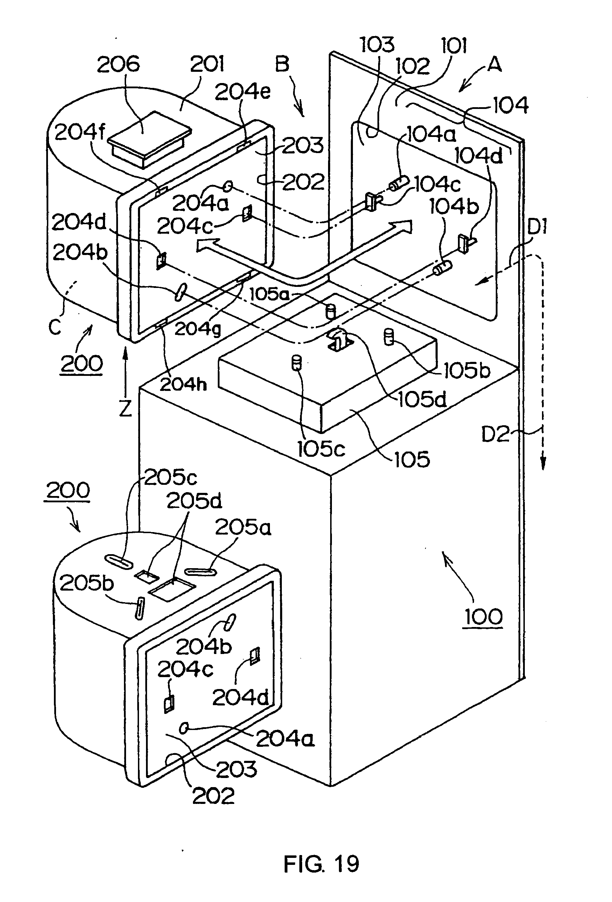

Figure 19 shows an example of a conventional pod cover removing-installing apparatus.

This conventional pod cover removing-installing apparatus 100 is provided with a diaphragm 101 which partitions off a high clean space A and a low clean space B, an opening 102 formed in the diaphragm 101 that serves as a passage between the high clean space A and the low clean space B, a door 103 which opens and closes the opening 102 of the diaphragm 101, a latch mechanism 104 that latches the cover 203 of the pod 200, with two positioning pins 104a, 104b and two T-shaped keys 104c, 104d provided in the door 103, and a table 105 provided in the low clean space B for mounting the pod 200, which has three positioning pins 105a, 105b, 105c and one lock key 105d.

The pod 200 is a container with an extremely clean internal space C for containing a plurality of semiconductor wafers (25 wafers, for example).

This pod 200 is provided with a main container body 201, an opening 202 provided on one side of the main container body 201, a cover 203 for opening and closing the opening 202, the cover 203 having pin holes 204a, 204b for engaging the positioning pins 104a, 104b, and key holes 204c, 204d for engaging T-shaped keys 104c, 104d, and a bottom 205 having grooves 205a, 205b, 205c possessing a V-shaped section for engaging the positioning pins 105a, 105b, 105c, and a key hole 205d for engaging the lock key 105d.

When the pod 200 is placed on the table 105, the three positioning pins 105a, 105b, 105c engage the V-shaped section-possessing grooves 205a, 205b, 205c. In this instance, switching on a lock button, not shown in the drawing, causes the lock key 105d to move upward, become angled, and engage the key hole 205d. Then, the table 105 moves toward the diaphragm 101 for a prescribed distance (about 30 mm, for example), thereby causing the pod 200 to become attached to the diaphragm 101. A sealing material such as an O-ring, not shown in the figure, is provided along the circumference of the opening 102 of the diaphragm 101 and the opening 202 of the pod 200, to ensure close attachment of the openings and maintain cleanliness.

The movement of the table 105 causes the cover 203 of the pod 200 to become closely attached to the door 103, whereby the positioning pins 104a, 104b engage the pin holes 204a, 204b of the cover 203 and the T-shaped keys 104c, 104d engage the key holes 204c, 204d. Thereafter, the T-shaped keys 104c, 104d are rotated 90° by a rotary actuator or the like, not shown in the figure, whereby nails 204e to 204h are pulled in to release the lock between the container main body 201 and the cover 203.

Then, the door 103 is pulled into the space A (arrow D1) and caused to descend (arrow D2) by a drive mechanism, not shown in the figure, whereby the internal space C of the pod 200 and the internal space A of the partition board 101 are brought into communication while maintaining cleanliness.

In the above-described conventional technology, if some trouble occurs during previous steps or during a carrying operation from a previous step, one or both rectangular engaging grooves (not shown) in key holes 204c, 204d that should engage the T-shaped keys 104c, 104d in the pod 200 run out of alignment in the rotational direction and cannot engage the T-shaped keys 104c, 104d, resulting in a problem that the cover 203 cannot be unlocked from the main container body 201.

For example, in the pod cover removing-installing apparatus in the previous step, the cover cannot smoothly open or close, and is suspended in the state in which the rectangular engaging grooves run out of alignment in the rotational direction.

In this instance, the automation line stops and it takes a long period of time for restoring the line. In addition, if the cover of the recovered pod is manually opened in a less clean chamber, expensive wafers stored in the pod may become unusable.

An object of the present invention is to provide a pod cover removing-installing apparatus usable with various pods manufactured by different manufacturers according to the SEMI standard and capable of releasing lock of the cover when rectangular engaging grooves run out of alignment during previous steps or during a carrying operation from a previous step.

### SUMMARY OF THE INVENTION

To achieve the above object, a first invention provides a pod cover removing-installing apparatus to remove and install a cover for an opening of a pod, the inside of which is kept extremely clean, by causing the cover to engage a door of an opening of a highly clean room, while maintaining high cleanliness of the pod and the room by closely attaching the circumference of the two openings, the cover being provided with a lock mechanism for locking and unlocking the opening of the pod by rotation of a rectangular key groove provided inside the rectangular key hole, wherein the door is provided with a locking member having a T-shaped key, the head of which engages the rectangular key groove via the rectangular key hole of the cover, and driving to lock or unlock the lock mechanism by the rotation of the T-shaped key, and the T-shaped key is provided in the head section thereof with an engagement allowance section for allowing the engagement of the head with the rectangular key groove according to deviation of the rotation angle of the rectangular key groove of the rock mechanism.

A second invention provides the pod cover removing-installing apparatus of the first invention, wherein the engagement allowance section consists of inclined sides extending along the both longitudinal sides of the head and tapering from the center toward the end.

A third invention provides the pod cover removing-installing apparatus of the second invention, wherein the engagement allowance section consists of chamfers formed on the top of the inclined sides.

A fourth invention provides the pod cover removing-installing apparatus of the first invention, provided with a drive control means for controlling the locking member to perform a locking motion after the T-shaped key has been rotated for a prescribed angle.

A fifth invention provides the pod cover removing-installing apparatus of the first invention, provided with a drive control means for controlling the locking member to perform a locking motion after the T-shaped key has been rotated for the number of times, each time for a prescribed angle, until the head of the T-shaped key engages the rectangular key groove.

A sixth invention provides the pod cover removing-installing apparatus of the first invention, wherein the T-shaped key is provided with a rotation allowable section on the head to allow rotation of the head according to deformation of the periphery of the rectangular key hole of the cover.

A seventh invention provides the pod cover removing-installing apparatus of the sixth invention, wherein the rotation allowance section consists of chamfers formed on the jaw side of the inclined sides.

### BRIEF DESCRIPTION OF THE DRAWINGS

Figure 1 is a perspective view showing an outline of a first embodiment of the cover removing-installing apparatus for a pod of the present invention.
Figure 2 is a front view of the first embodiment of the cover removing-installing apparatus for a pod of the present invention.
Figure 3 is an enlarged view of the part III of Figure 2 and shows the fine adjustment mechanism for the pod cover removing-installing apparatus of the first embodiment.
Figure 4 is an enlarged view of the part IV of Figure 2 and shows the centering mechanism for the pod cover removing-installing apparatus of the first embodiment.
Figure 5 is a cross sectional view along the line V-V of Figure 2 and shows the holding mechanism of the pod cover removing-installing apparatus of the first embodiment.
Figure 6(a) is a perspective view and Figure 6(b) is a cross sectional view along the line VI-VI of Figure 2, showing an eccentric transmission mechanism for the pod cover removing-installing apparatus of the first embodiment.
Figure 7 is a cross sectional view along the line VII-VII of Figure 2 and shows the positioning securing means of the pod cover removing-installing apparatus of the first embodiment.
Figure 8 is a block diagram showing a control means for the pod cover removing-installing apparatus of the first embodiment.
Figure 9 is a flowchart showing an operational example (cover opening operation 1) for the pod cover removing-installing apparatus of the first embodiment.
Figure 10 is a flowchart showing an operational example (cover opening operation 2) for the pod cover removing-installing apparatus of the first embodiment.
Figure 11 is a flowchart showing an operational example (cover closing operation 1) for the pod cover removing-installing apparatus of the first embodiment.
Figure 12 is a flowchart showing an operational example (cover opening operation 2) for the pod cover removing-installing apparatus of the first embodiment.
Figure 13 shows a T-shaped key unit for the pod cover removing-installing member of the first embodiment, wherein Figure 13(a) is a plan view, Figure 13(b) is a side view, and Figure 13(c) is a front view.
Figure 14 shows a T-shaped key unit extracted from Figure 13, wherein Figure 14(a) is a front view, Figure 14(b) is a side view, Figure 14(c) is a plan view, and Figure 14(d) is an enlarged view of the D section of Figure 14(a).
Figure 15 is a drawing for describing the shape and engagement movement of The T-shaped key 104c.
Figure 16 is a drawing for describing the shape and engagement movement of The T-shaped key 14c-1.
Figure 17 is a drawing for describing the shape and engagement movement of The T-shaped key 14c.
Figure 18 is a flow chart showing subroutine for the unlock operation of a motor 71 for locking the cover of S105 in Figure 9.
Figure 19 shows an example of a conventional pod cover removing-installing apparatus.

### DETAILED DESCRIPTION OF THE INVENTION AND PREFERRED EMBODIMENTS

The present invention will be described in more detail by way of preferred embodiments with reference to the attached drawings.

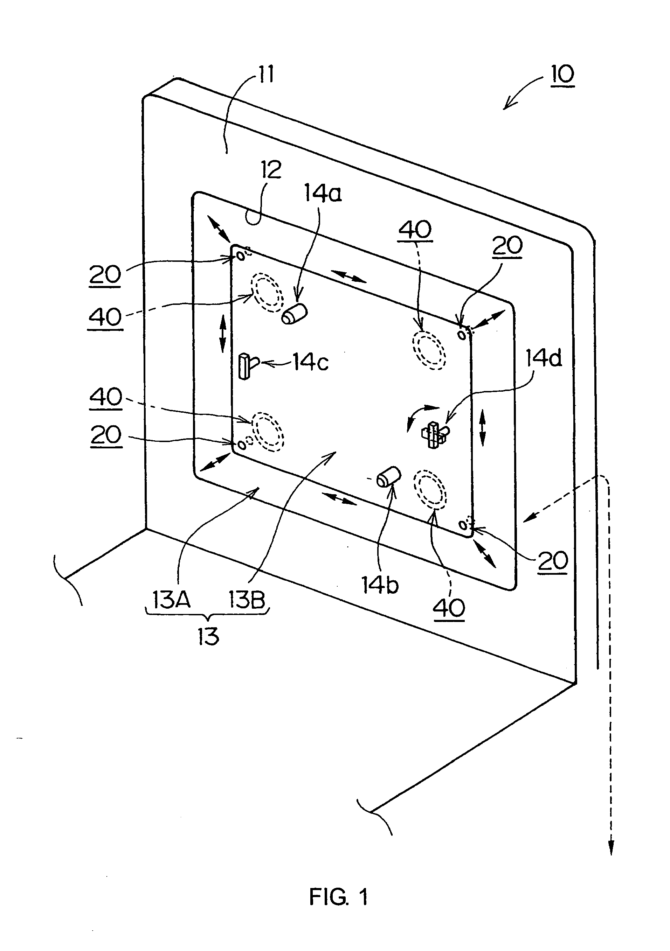

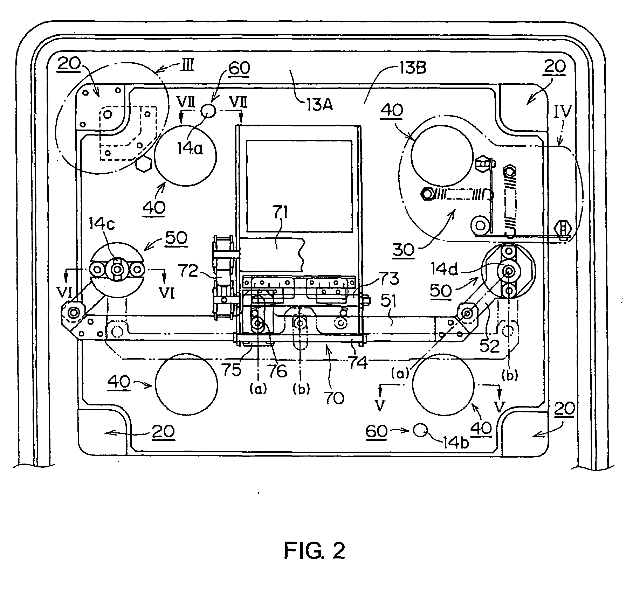

Figures 1 and 2 are drawings showing a first embodiment of the pod cover removing-installing apparatus of the present invention, wherein Figure 1 is a perspective view showing an outline and Figure 2 is a plan view of the apparatus.

This pod cover removing-installing apparatus is provided with a diaphragm 11, an opening 12, a door 13 which opens and closes the opening 12 of the diaphragm 11, two positioning pins 14a, 14b and two T-shaped keys 14c, 14d, a latch mechanism 14 which opens and closes a cover 203 of a pod 200, and the like.

In the first embodiment, the door 13 is provided with a base plate 13A and a position adjusting plate 13B movable in the direction vertical to the plane so that its position can be adjusted with respect to the base plate 13.

The door 13 is provided therein with four fine adjustment mechanisms 20, two centering mechanisms 30, four holding mechanisms 40, two eccentric transmission mechanisms 50, one positioning fixing means 60, and the like.

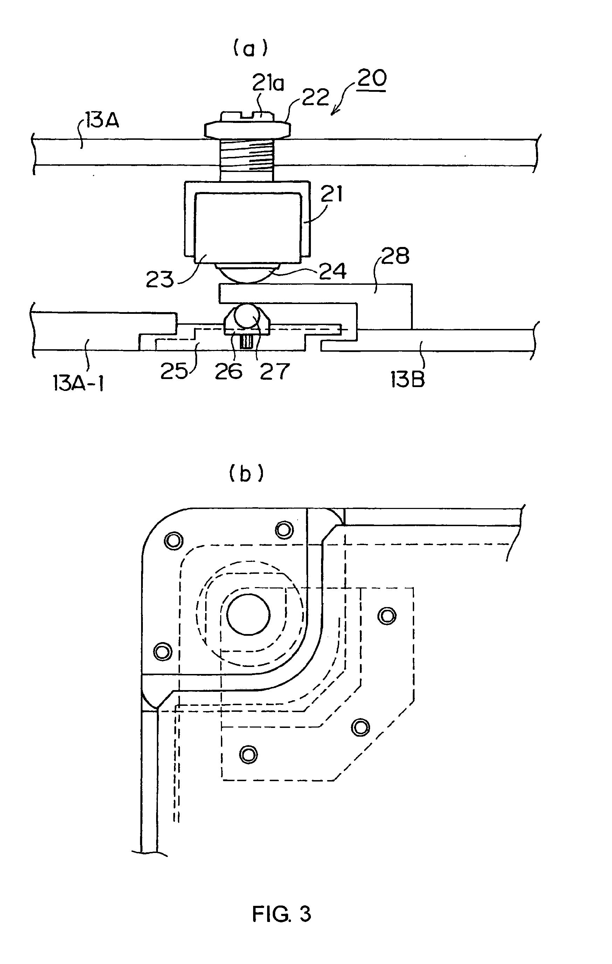

Figure 3(a) and Figure 3(b) are enlarged views of the part III of Figure 2 and show the fine adjustment mechanism for the pod cover removing-installing apparatus of the first embodiment.

The fine adjustment mechanism 20 supports the position adjusting plate 13B movable in the direction vertical to the plane and exactly adjusts the position of the positioning pins 14a and 14b. This fine adjustment mechanism 20 is provided in the four corners of the position adjusting plate 13B (see Figure 1), each having a fixture 21 for fastening and securing the base plate 13A using a thread 21a, a female screw 22 for keeping the fixture 21 from loosening, a receiving member 23 of free bearings and the like inserted into the fixture 21, a ball 24 rotatively supported by the receiving member 23, an opposing plate 25 provided in the base plate frame 13A-1 on the opposing side, a receiving member 26 provided in the opposing plate 25, a ball 27 rotatively supported in the receiving member 26, a guide plate 28 provided on the side of position adjusting plate 13B and movably squeezed by the ball 24 and the ball 27.

The fine adjustment mechanism 20 is designed so that in the initial state in which the positioning pins 14a, 14b engage the pin holes 204a, 204b of the pod 200 (see Figure 19), tapered tips of the positioning pins 14a, 14b move a prescribed distance (e.g. 3 mm in every direction) vertically to the plane, while the tapered tips match the tapered pin holes 204a, 204b. For this reason, even if there is some error in the position of the pin holes 204a, 204b of the pod 200, the positioning pins 14a, 14b can easily engage these pin holes without colliding.

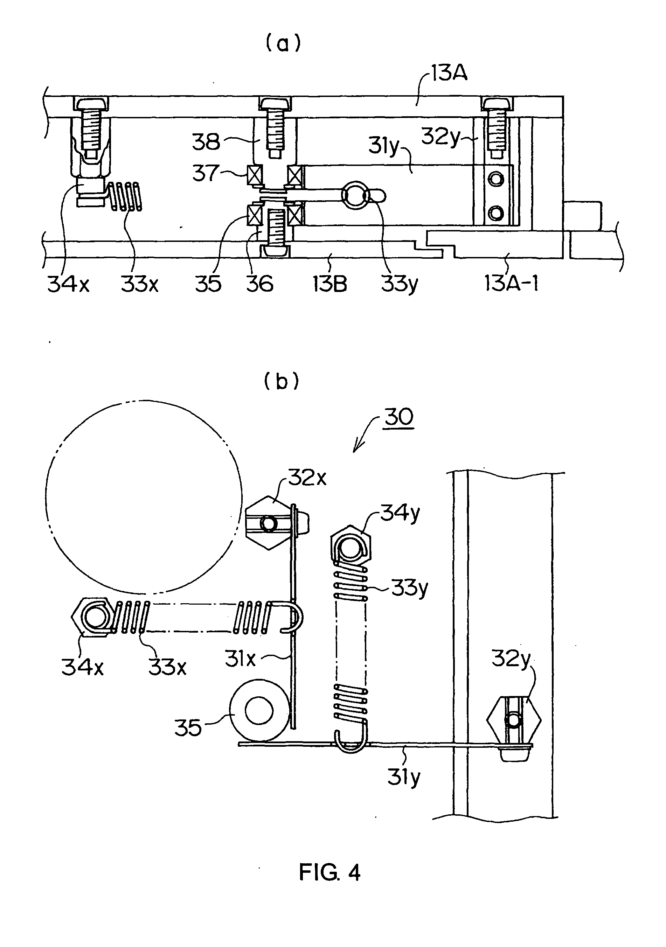

Figure 4(a) and Figure 4(b) are enlarged views of the part IV of Figure 2 and show the centering mechanism for the pod cover removing-installing apparatus of the first embodiment.

The centering mechanism 30 is a mechanism for causing the position adjusting plate 13B to return to the center. The centering mechanism 30, consisting of two systems, one in the horizontal direction (x direction) and the other in the vertical direction (y direction), is provided with press boards 31x, 31y, securing members 32x, 32y for securing the press boards 31x, 31y in the base plate 13A, coil springs 33x, 33y for moving the press boards 31x, 31y to the center, securing members 34x, 34y for securing the other ends of the coil springs 33x, 33y to the base plate 13A, guide pieces 35, 37 which come into contact with the press boards 31x, 31y, securing members 36, 38 for securing the guide pieces 35, 37 in the position adjusting plate 13B and base plate 13A, and the like.

The press board 31x aligns the guide pieces 35, 37 on a straight line in the X direction. In the same manner, the press board 31y aligns the guide pieces 35, 37 on a straight line in the Y direction. The position adjusting plate 13B is centered by these actions.

Although omitted from Figure 2, a mechanism which is the same but symmetrical with the mechanism shown in the upper right side is provided in the upper left side of the Figure 2.

Because the position adjusting plate 13B can move vertical to the plane with respect to the base plate 13A by means of the fine adjustment mechanism 20, the centering mechanism 30 always causes the position adjusting plate 13B to be positioned in the previously determined center position (the engaging position without an error) in the initial state in which the positioning pins 14a, 14b engage the pin holes 204a, 204b of the pod 200 (see Figure 19).

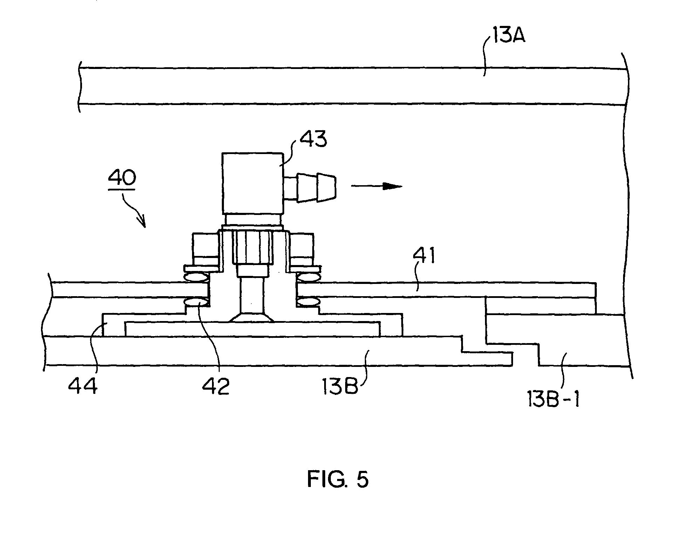

Figure 5 is a cross sectional view along the line V-V of Figure 2 and shows the holding mechanism of the pod cover removing-installing apparatus of the first embodiment.

The holding mechanism 40 holds the position adjusting plate 13B to the cover 203 of the pod 200 at the position where the positioning pins 14a, 14b engage. The holding mechanism 40 has a securing plate 41 provided in a base plate frame 13A-1, a joint 43 connected with this securing plate 41 through the O-ring 42, having a nozzle (not shown in the figure) connected to a vacuum pressure source, and an absorption pad 44 provided in the joint 43 which is capable of being attached to the position adjusting plate 13B.

Because the position adjusting plate 13B can move vertical to the plane with respect to the base plate 13A by means of the fine adjustment mechanism 20, the holding mechanism 40 can hold the positioning pins 14a, 14b to engage the pin holes 204a, 204b of the pod 200 (see Figure 19). This structure ensures that the container maintains the same position as the position before removal when the cover 203 has been once removed and returned thereafter. Therefore, the cover can be closed without impediment.

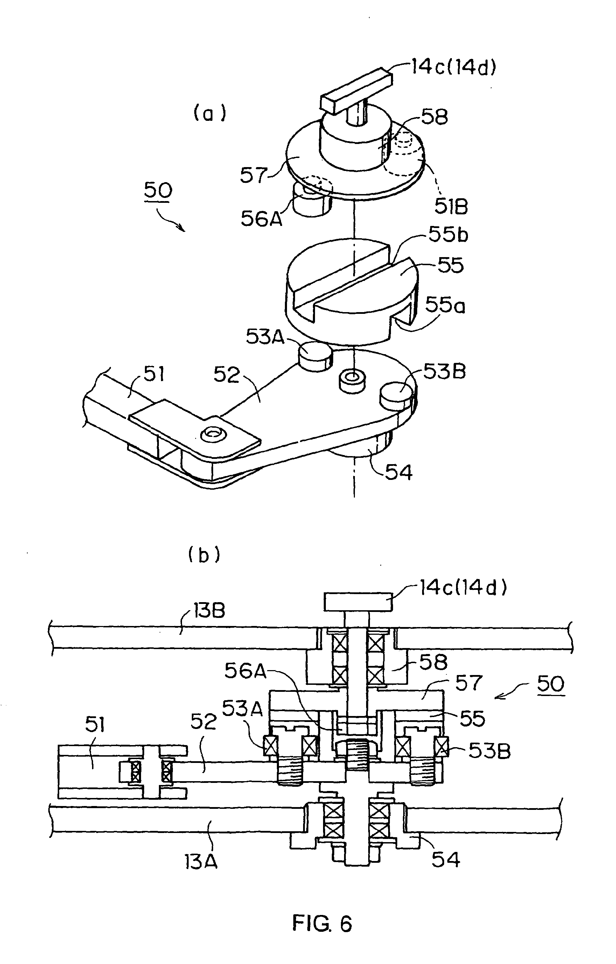

Figure 6(a) is a perspective view and Figure 6(b) is a cross sectional view along the line VI-VI of Figure 2, showing an eccentric transmission mechanism for the pod cover removing-installing apparatus of the first embodiment.

The T-shaped key 14c (14d) is provided in a prescribed position of the position adjusting plate 13B to engage the key hole 204c (204d) of the cover 203 to lock the cover 203, and driven by a lock drive mechanism 70 (see Figure 2). This lock drive mechanism 70 is provided on the side of the base plate 13A and rotates in either direction around the axis of the T-shaped key 14c (14d) to perform locking or unlocking movements.

Because it is desirable to make the position adjusting plate 13B light for ease of movement, the lock drive mechanism 70 and the like are preferably installed on the base plate 13A. For this reason, an eccentric transmission mechanism 50 is provided to transmit a driving force from the lock drive mechanism 70 to the T-shaped key 14c (14d).

This eccentric transmission mechanism 50 allows a deflection of the base plate 13A and position adjusting plate 13B in the direction vertical to the plane and transmits a rotational force of the lock drive mechanism 70 to the T-shaped key (locking member) 14c (14d).

As shown in Figure 6, the eccentric transmission mechanism 50 has a driving lever 51 connected to the lock drive mechanism 70, a rotation lever 52 rotatively connected to the driving lever 51, a bearing 54 supporting the rotation lever 52 on the base plate 13A in a freely rotative manner, transmission rollers 53A, 53B provided on the rotation lever 52, a slide disc 55 having grooves 55a, 55b orthogonally provided on both sides, into which the transmission rollers 53A, 53B and transmission rollers 56A, 56B are respectively inserted, a rotation board 57 provided on the same axis with the T-shaped key 14c (14d), a bearing 58 having the transmission rollers 56A, 56B provided therein and supporting the axis of the rotation board 57 and the T-shaped key 14c (14d) on the position adjusting plate 13B in a freely rotative manner, and the like.

The eccentric transmission mechanism 50 transmits a rotational force of the lock drive mechanism 70 to the T-shaped key 14c (14d), even if the position adjusting plate 13B deviates from its original position within a movable range in the direction vertical to the plane.

Here, as shown in Figure 2, the lock drive mechanism 70 is provided with a motor 71, a drive screw 73 to which the rotation of the motor 71 is transmitted by a belt 72, a slide axis 74 arranged in parallel with the drive screw 73, a moving block 75 freely slidably supported in the slide axis 74 and driven by a drive screw 73, a bearing 76 secured on a moving block 75 and engaging a long hole in the driving lever 51, and the like.

When the bearing 76 is in the position (a), the rotation lever 52 is in the position (a). When the bearing 76 moves to the right and comes to the position (b), the rotation lever 52 rotates. This causes the driving lever 51 to move that distance and to descend to the point indicated by a chain line connected by two dots. Because the bearing 76 is secured on the moving block 75, the horizontal level of the position (b) remains the same as that of the position (a). Because of this, a deviation of the engaging position of the driving lever 51 and the bearing 76 is absorbed by the long hole of the driving lever 51.

The T-shaped key 14c (14d) featuring the present invention will now be described in detail.

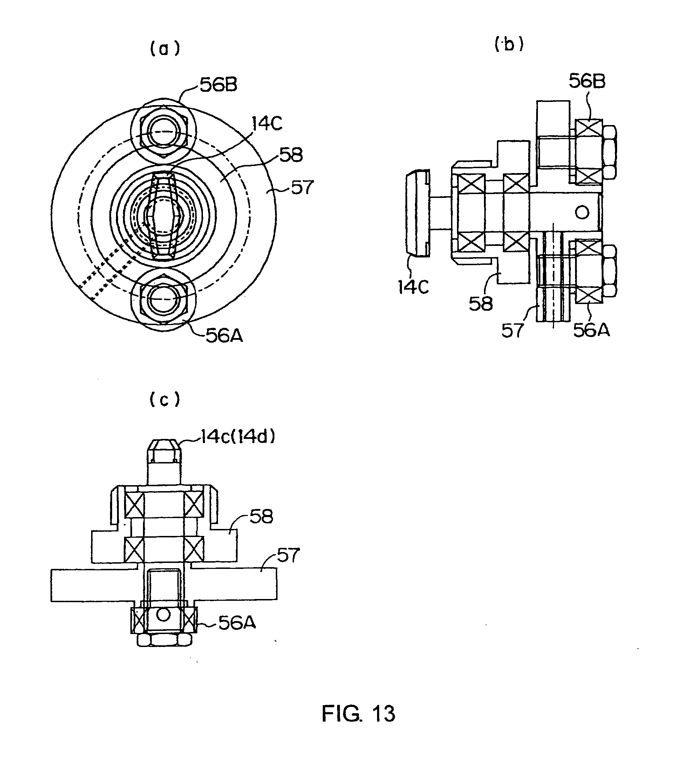

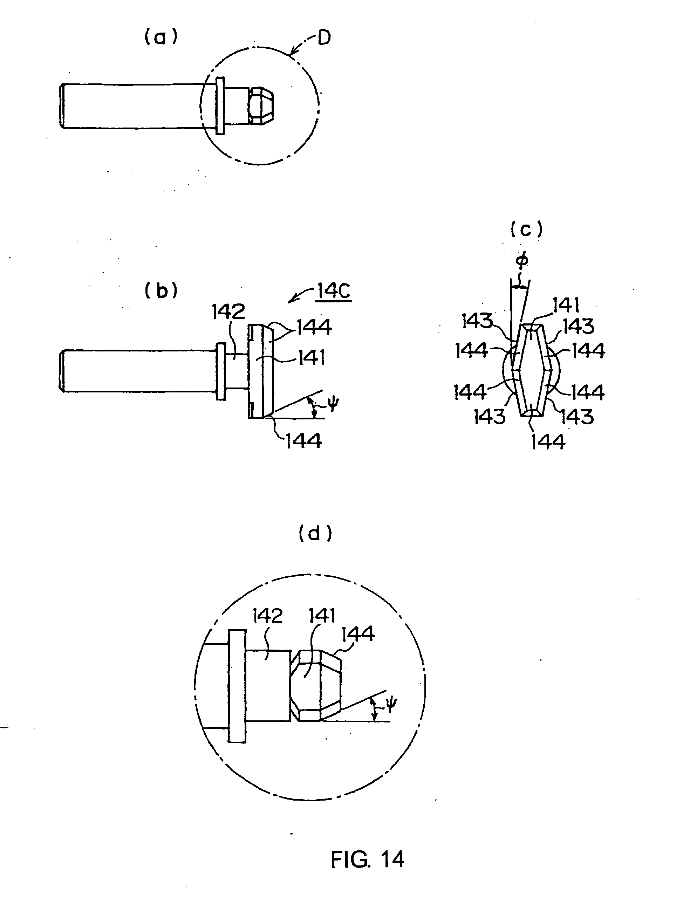

Figure 13 shows a T-shaped key unit of the cover removing-installing apparatus of the first embodiment and Figure 14 shows the T-shaped key extracted from Figure 13. Since the T-shaped keys 14c and 14d have the same shape, only the T-shaped key 14c will be described.

As shown in Figure 13, the T-shaped key unit comprises the T-shaped key 14c, transmission rollers 56A, 56B, a rotation board 57 provided coaxially with the T-shaped key 14c, a bearing 58 rotatably supporting the axis of the rotation board 57 and T-shaped key 14c on the positioning plate 13B, and the like.

As shown in Figure 14, the T-shaped key 14c consists of a head 141 and a neck 142 functioning as a rotation axis for the head 141. The head 141 has four inclined sides 143 along the both longitudinal sides tapering from the center toward the end. An angle of inclination (f) of about 8-10° has been confirmed to be sufficient for the inclined sides 143 by experiments of the present inventor.

The T-shaped key 14c has a chamfer 144 on the topside of each inclined side 143. An angle of the chamfer (ψ) of about 10-12° has been confirmed to be sufficient for the chamfers 144 by experiments of the present inventor.

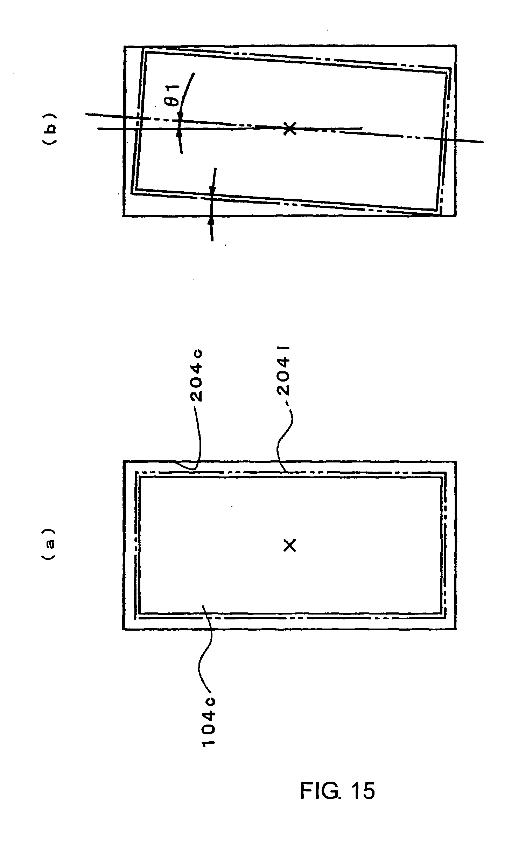

Figures 15-17 are drawings for describing the shape and engagement movement of the T-shaped key 14c.

In Figure 15(a), 204c indicates a rectangular key hole, 104c is a conventional T-shaped key, and 204i is a rectangular key groove. In this embodiment, since there is a clearance between the T-shaped key 104c and the key hole 204c, the T-shaped key 104c can engage the rectangular key groove 204i via the key hole 204c even if the rectangular key groove 204i is out of alignment at an angle of θ1 = a (the deviation allowance due to the clearance, the clearance is 0.3-0.5 mm and a is about 4° in this embodiment) as shown in Figure 15(b).

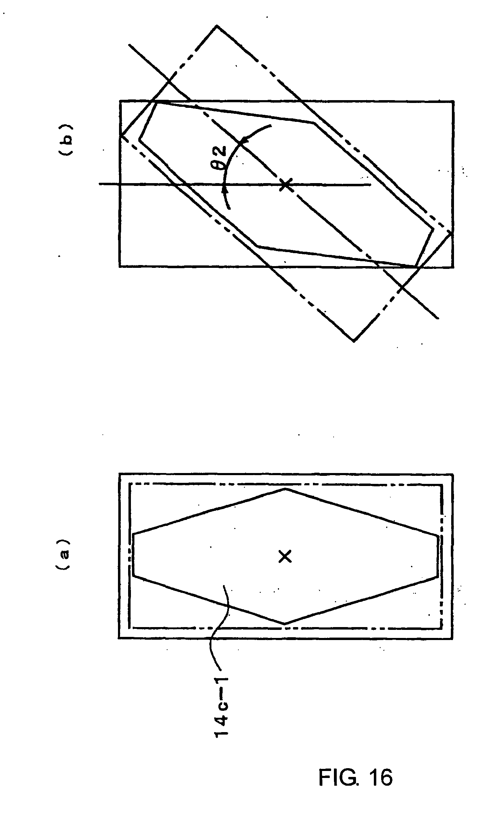

In Figure 16(a), the T-shaped key 14c-1 does not have the chamfers 144 for the T-shaped key 14c described in Figure 14. In this embodiment, since the T-shaped key 14c-1 has inclined sides 143, the T-shaped key 14c-1 can engage the rectangular key groove 204i via the key hole 204c even if the rectangular key groove 204i is out of alignment at an angle of θ2 = a + β (wherein β is the deviation allowance angle due to the inclined sides 143) as shown in Figure 16(b). When the angle of inclination of the inclined sides 143 (f) is 8°, β is about 16°, and θ2 is 20°.

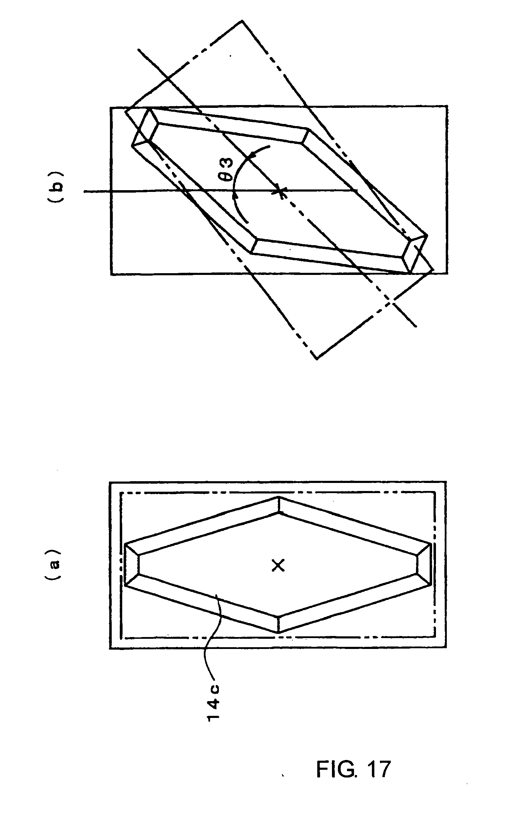

In Figure 17(a), the T-shaped key 14c has the chamfers 144 described in Figure 14. In this embodiment, since the T-shaped key 14c has the chamfers 144, the T-shaped key 14c can engage the rectangular key groove 204i via the key hole 204c even if the rectangular key groove 204i is out of alignment at an angle of θ3 = a + β + γ (wherein γ is the deviation allowance angle due to the angle of the chamfers 144) as shown in Figure 17(b). When the angle of the chamfers 144 (ψ) is about 30°, γ is about 10°, and θ3 is 30°.

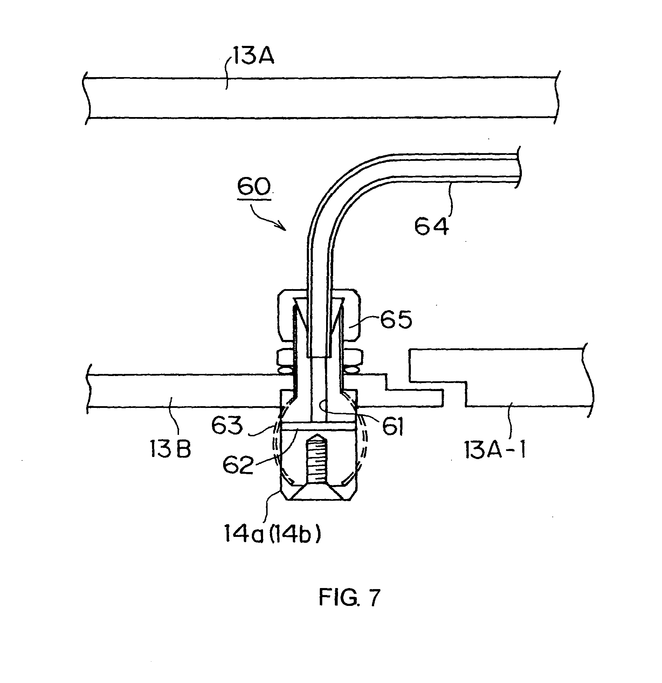

Figure 7 is a cross sectional view along the line VII-VII of Figure 2, and shows the position securing means of the pod cover removing-installing apparatus of the first embodiment.

The position securing means 60 of this embodiment has a passage 61 provided in the axial direction of the positioning pin 14a (14b), a passage 62 provided in the vertical direction of the passage 61 and joining therewith, a stretch member 63 formed from rubber such as neoprene provided around the circumference of the positioning pin 14a (14b) and capable of stretching according to an increase or decrease in the internal pressure, a pipe 64 connected with the passage 61, a securing member 65 for securing the pipe 64 at the rear end of the positioning pin 14a (14b), and the like.

In this position securing means 60, pipe 64 is connected to a pneumatic circuit or a vacuum circuit, not shown in the figure, which causes the internal pressure of the passages 61, 62 to increase or decrease, thereby causing the stretch member 63 to expand or contract, causing the gap between the positioning pins 14a, 14b and the pin holes 204a, 204b to be filled out. The positioning pins 14a, 14b are secured in the position in this manner.

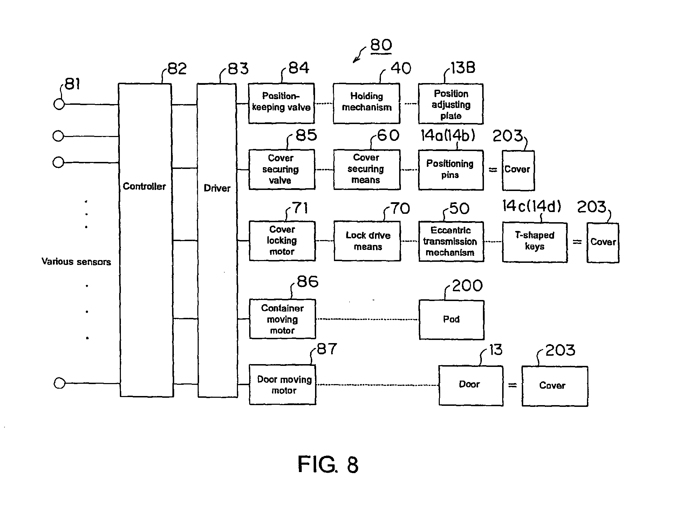

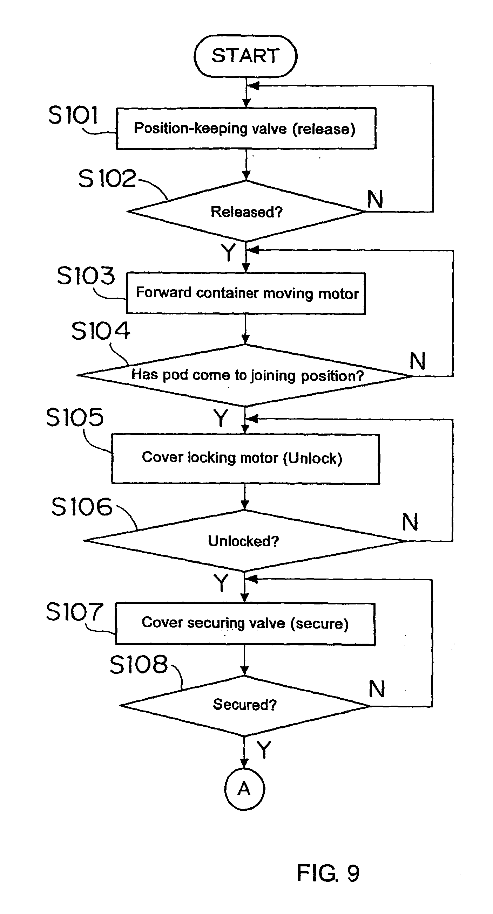

Figure 8 is a block diagram showing a control means for the pod cover removing-installing apparatus of the first embodiment, and Figures 9-12 are flow charts showing operations of the cover removing-installing apparatus.

The control means 80 has various sensors 81 for detecting the positions and the like of each moving part, a controller 82 which produces various control signals to control each drive part, described later, based on the position detection signals from the sensors 81, a driver 83 for converting control signals from the controller 82 into drive signals conforming to each drive part, and a drive part driven based on the drive signals from the driver 83, including a position-keeping valve 84 which controls the flow of the air pressure to the holding mechanism 40, a cover securing valve 85 which controls the flow of the air pressure to a cover securing means 60, a cover locking motor 71 of a lock drive means 70, a container moving motor 86, a door moving motor 87, and the like.

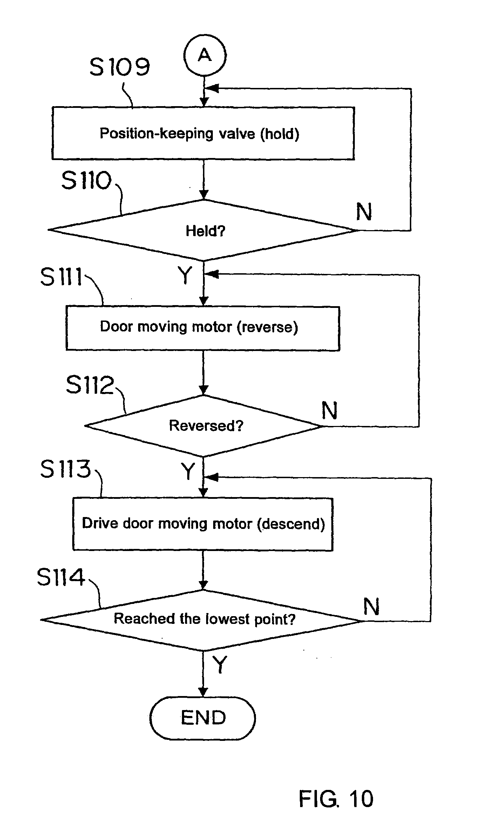

Next, the cover opening operation will be described referring to Figures 9 and 10.

The controller 82 drives the position-keeping valve 84 to the release side (Step 101, the step is hereinafter referred to as "S") and, upon confirmation of release with a sensor (S102, YES), drives the container moving motor 86 to move the pod 200 forward (S103), then, upon confirmation that the pod 200 has come to the joining position (S104, YES), stops the container moving motor 86.

Because the holding mechanism 40 is canceled in this state by the position-keeping valve 84, the position adjusting plate 13B is not only free, but also has been moved to the center by the centering mechanism 30. When the pod 200 comes to the joining point, the position adjusting plate 13B can be moved by the fine adjustment mechanism 20, enabling the complete joining of the cover 203 of the pod 200 and the door 13 even though the pin holes 204a and 204b of the pod 200 deviate in the allowable range with respect to the positioning pins 14a, 14b.

Next, the cover locking motor 71 is driven to the unlock side (S105) and the T-shaped keys 14c and 14d are rotated to retract the nails 204e-204h of the cover 203. When the sensor confirms that the nails 204e-204h have been retracted (unlock) (S106, YES), the cover securing valve 85 is driven to the securing side (S107) to expand the stretch member 63 of the positioning pins 14a, 14b, confirming the securing of the pin holes 204a, 204b with the sensor (S108, YES).

In the final stage of the operation S107, even if there is a deviation between the positioning pins 14a, 14b and pin holes 204a, 204b, and the position adjusting plate 13B has been moved, the T-shaped keys 14c, 14d can rotate due to the eccentric transmission mechanism 50.

Moreover, accurate positioning is possible because the pin holes 204a, 204b are secured by expanding the stretch member 63 of the positioning pins 14a, 14b.

Next, as shown in Figure 10, the position-keeping valve 84 is driven to the hold side (S109), confirming the holding with the sensor (S110, YES), and causing the door to reverse by driving the door moving motor 87 (S111). Upon confirmation that the door has reversed (S112, YES), the door moving motor 87 is further driven to move the door downward (S113). When the door has reached the lower limit (S114, YES), the operation to terminate the process is stopped.

In this state, the position-keeping valve 84 is driven to the hold side and holds the position of the position adjusting plate 13B in its original position in the later-described door closing operation. Therefore, the door does not collide with the opening 202 of the pod 200 when closed.

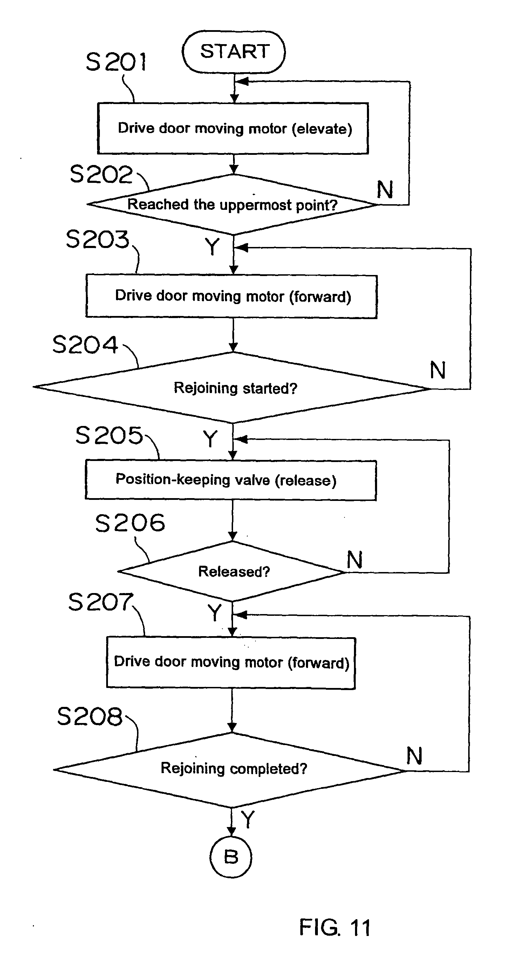

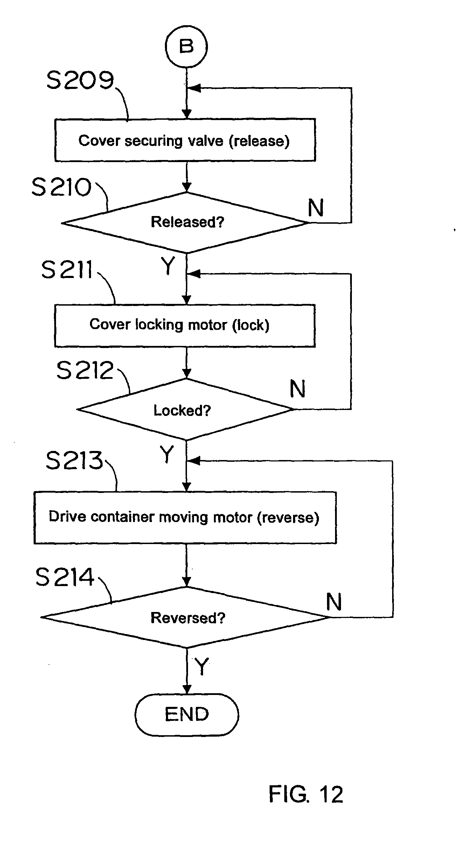

Next, the cover closing operation will be described referring to Figures 11 and 12.

Referring to Figure 11, the controller 82 drives the door moving motor 87 to elevate (S201) to the upper limit point (S202, YES), then to go forward (S203) until the door 13 starts rejoining the pod 200. Upon confirmation of the initiation of rejoining by a sensor (S204, YES), the position-keeping valve 84 is driven to the release side (S205). Upon confirmation of the release by a sensor (S206, YES), the door moving motor 87 is driven forward (S207) until rejoining is complete, whereupon the door moving motor 87 is stopped and the rejoining with the pod 200 is confirmed by a sensor (S208).

Next, the cover securing valve 85 is driven to the release side (S209) to cause the stretch member 63 of the positioning pins 14a, 14b to become contracted. The release from the pin holes 204a, 204b is confirmed by a sensor (S210, YES). The cover locking motor 71 is driven to the lock side (S211) to rotate the T-shaped keys 14c, 14d and cause the nails 204e to 204h to protrude and lock the cover, which is confirmed by a sensor (S212, YES).

Finally, the container moving motor 86 is driven to move the pod 200 backward (S213). Upon confirmation by a sensor that the pod 200 has reversed (S214, YES), the container moving motor 86 is stopped to terminate the cover closing operation.

Next, the T-shaped key control operation when the rectangular key groove 204i of the cover 203 is out of alignment, featuring the present invention, will be described.

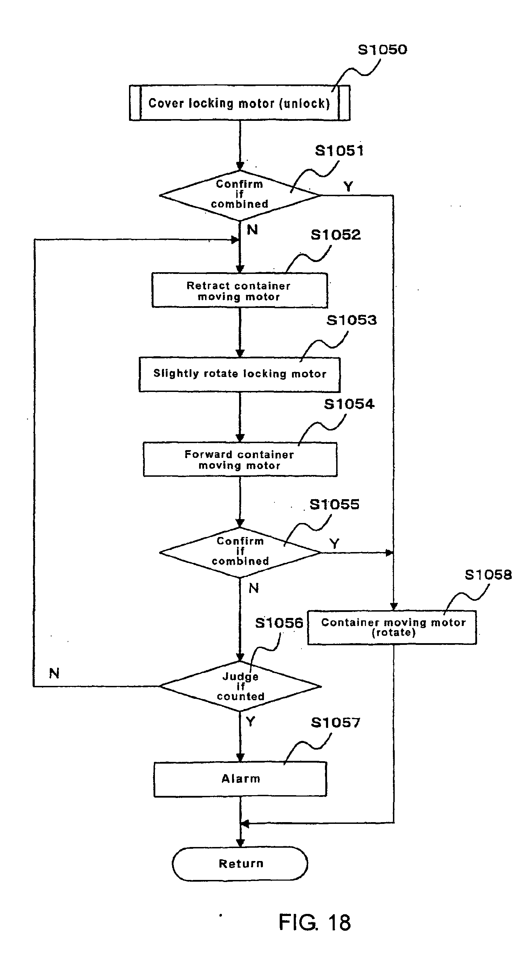

Figure 18 is a flow chart showing subroutine for the unlock operation of a motor 71 for locking the cover of S105 in Figure 9.

When S1050 in Figure 18 is called for by S105 in Figure 9, whether or not the heads 141 of the T-shaped keys 14c, 14d have engaged the rectangular key grooves 204i is judged (S1051). When the answer is YES, the operation proceeds to S1058 in which the cover locking motor 71 is rotationally driven to the unlock side, and then the operation returns to the flow of Figure 9.

When the answer of S1051 is NO, a pod moving motor 86 is withdrawn (S1052) and T-shaped keys 14c and 14d are rotated a small angle (in this case about 3o) by a cover locking motor 71 (S1053).

The pod moving motor 86 is then driven forward (S1054) again to judge whether the heads 141 of the T-shaped keys 14c, 14d have engaged the rectangular key groove 204i (S1055). If the response in S1055 is YES, the operation proceeds to S1058; if NO, the operation proceeds to S1056.

A prescribed number of operations (four times here) is counted. Whether or not the number has been counted up to four is judged (S1056). If the response is NO, the operations of S1052-S1055 are repeated; if YES, the operation proceeds to S1057, wherein an alarm is given, and then the operation returns to the flow of Figure 9.

As described above, since the T-shaped key 14c is provided with the inclined sides 143 and chamfers 144 and, in addition, is rotated a small angle during an engaging operation, the T-shaped key 14c can engage the rectangular key groove 204i via the key hole 204c, even if the rectangular key groove 204i is out of alignment with respect to the key hole 204c.

### (Modification)

The present invention is not limited to the above-described embodiments and can be varied or modified in various ways. Such variations and modifications are within the scope of equivalency of the present invention.
(1) For example, in Figure 18, when the answer to the judgment (S1051) as to whether the engagement has been successfully completed is NO, the T-shaped keys 14c and 14d may be rotated a small angle by a cover locking motor 71 (S1053) without withdrawing the pod moving motor 86. In this instance, whether or not the engagement at that position has been successful may be again judged (S1055).
(2) When the T-shaped keys 14c and 14d are not engaged in the operation of Figure 18, the T-shaped keys 14c and 14d are restored to the original angle (0°) to repeat the operation of Figure 18.
(3) Although an embodiment of the T-shaped key 14c with the chamfers 144 was described, the T-shaped key 14c-1 without the chamfers 144 described in Figure 16 is also within the scope of the present invention.
(4) The T-shaped key 14c may have a chamfer (rotation allowance) 145 on the jaw side of the inclined side 144 of the head 141. This arrangement ensures rotation of The T-shaped key 14c even if the periphery of the key holes 204 of the cover 203 inwardly deforms.

## Claims

1. A pod cover removing-installing apparatus to remove and install a cover for an opening of a pod, the inside of which is kept extremely clean, by causing the cover to engage a door of an opening of a highly clean room, while maintaining high cleanliness of the pod and the room by closely attaching the circumference of the two openings, the cover being provided with a lock mechanism for locking and unlocking the opening of the pod by rotation of a rectangular key groove provided inside the rectangular key hole, wherein the door is provided with a locking member having a T-shaped key, the head of which engages the rectangular key groove via the rectangular key hole of the cover, and driving to lock or unlock the locking mechanism by the rotation of the T-shaped key, and the T-shaped key is provided with an engagement allowance section for allowing the engagement of the head with the rectangular key groove according to deviation of the rotation angle of the rectangular key groove of the rock mechanism.

2. The pod cover removing-installing apparatus according to claim 1, wherein the engagement allowance section consists of inclined sides extending along the both longitudinal sides of the head and tapering from the center toward the end.

3. The pod cover removing-installing apparatus according to claim 2, wherein the engagement allowance section consists of chamfers formed on the top of the inclined sides.

4. The pod cover removing-installing apparatus according to claim 1, provided with a drive control means for controlling the locking member to perform a locking motion after the T-shaped key has been rotated a prescribed angle.

5. The pod cover removing-installing apparatus according to claim 1, provided with a drive control means for controlling the locking member to perform a locking motion after the T-shaped key has been rotated the number of times, each time a prescribed angle, until the head of the T-shaped key engages the rectangular key groove.

6. The pod cover removing-installing apparatus according to claim 1, wherein the T-shaped key is provided with a rotation allowable section on the head to allow rotation of the head according to deformation of the periphery of the rectangular key hole of the cover.

7. The pod cover removing-installing apparatus according to claim 6, wherein the rotation allowance section consists of chamfers formed on the jaw side of the inclined sides.

## Amended claims

### Amended claims under Art. 19.1 PCT

1. (Canceled)

2. (Amended) A pod cover removing-installing apparatus to remove and install a cover for an opening of a pod, the inside of which is kept extremely clean, by causing the cover to engage a door of an opening of a highly clean room, while maintaining high cleanliness of the pod and the room by closely attaching the circumference of the two openings, the cover being provided with a lock mechanism for locking and unlocking the opening of the pod by rotation of a rectangular key groove provided inside the rectangular key hole, wherein the door is provided with a locking member having a T-shaped key, the head of which engages the rectangular key groove via the rectangular key hole of the cover, and driving to lock or unlock the locking mechanism by the rotation of the T-shaped key, the T-shaped key is provided with an engagement allowance section for allowing the engagement of the head with the rectangular key groove according to deviation of the rotation angle of the rectangular key groove of the rock mechanism, and the engagement allowance section consists of inclined sides extending along the both longitudinal sides of the head and tapering from the center toward the end.

3. The pod cover removing-installing apparatus according to claim 2, wherein the engagement allowance section consists of chamfers formed on the top of the inclined sides.

4. (Canceled)

5. (Amended) The pod cover removing-installing apparatus according to claim 2, provided with a drive control means for controlling the locking member to perform a locking motion after the T-shaped key has been rotated the number of times, each time a prescribed angle, until the head of the T-shaped key engages the rectangular key groove.

6. (Amended) The pod cover removing-installing apparatus according to claim 2, wherein the T-shaped key is provided with a rotation allowable section on the head to allow rotation of the head according to deformation of the periphery of the rectangular key hole of the cover.

7. The pod cover removing-installing apparatus according to claim 6, wherein the rotation allowance section consists of chamfers formed on the jaw side of the inclined sides.
